# EUROPEAN PATENT APPLICATION

(11) **EP 1 447 714 A2**
(43) Date of publication of application: **18.08.2004**
(21) Application number: 03007559.2
(22) Date of filing: 01.04.2003
(51) Int. Cl.: G03F 7/20

(54) **Method for generating a circular periodic structure on a basic support material**

(30) Priority: 14.02.2003 EP 03003392
(71) Applicant: PAUL SCHERRER INSTITUT, 5232 Villigen PSI (CH)
(72) Inventor: David, Christian, 79787 Lauchingen (DE); Solak, Harun, 5200 Brugg (CH)
(74) Representative: Fischer, Michael, Dr.

(57) **Abstract**

The aim of the invention is to provide a method allowing generation of periodic curved structures in a basic support material such as the basic layer for the magnetic bit cells of a magnetic storage device.

This aim is achieved according to the invention by a method for generating a periodic circular structure for a support (12) for a magnetic storage device, comprising:
a) generating a number of masks with each mask having at least two transmission diffraction gratings (4, 6, 8, 20 to 34) each having a different periodic concentric circular and/or spiral-like periodic pattern;
b) positioning of one or more of said diffraction masks (4, 6, 8, 20 to 34) successively in a certain distance of a basic support material (12) to be patterned;
c) applying light beams through each of the diffraction masks (4, 6, 8, 20 to 34) for exposuring the basic support material to said light beam;
d) interfering the different light beams diffracted by the gratings on each mask in order to generate coincident light intensity pattern on the surface of the basic support material (12)
e) repeating the exposure procedure a number of times with different masks to obtain a desired pattern of a periodic circular structure with possible partitioning in the circumferential direction.

## Description

The invention relates to a method for generating a periodic circular structure in a basic support material, such as for patterning a basic layer for the magnetic bits of a magnetic disk media.

Magnetic recording devices in the form of circular discs coated uniformly with thin films of magnetic materials are used in many information systems. The data is recorded as magnetic bits in the thin film media. A magnetic bit means an area of the film that has been mainly magnetized in a direction by a writing head. The bits are read by a reading head which is sensitive to the magnetization orientation of the bits. The disc rotates usually around an axis perpendicular to the surface of the disc. During the rotation the write and/or read operations are performed. Therefore, the magnetic bits are positioned on circular tracks around the rotational axis.

The areal density of data stored on this kind of magnetic storage disks (i.e. so-called hard disks) has increased with an average annual growth range of about 60 to 100% each year since the early 90's. This tremendous growth rate allowed lower costs per stored bit and higher speed of data access. Storage devices having an areal density of about 60 Gbits/inch² are expected to be offered in the market in the near future, i.e. second half of 2003.

Consequently, the increase of the areal density can only be achieved by a decrease of the size of a magnetic bit cell.

For example, a 100 Gbits/inch² generation will require a size of a magnetic bit cell to be approximately 80x80 nm² assuming a square shaped bit cell. The magnetic bit cell in a thin film crystalline media may contain several tens to hundreds of magnetic grains. A respectable number of grains is required in order to allow an acceptable signal to noise ratio for each magnetic bit cell. Therefore, as far as the size of the magnetic bit cell has to decrease for the sake of higher areal densities, the size of grains must become smaller as well. However, the level of minimization will touch physical limits due to the so-called super-paramagnetic limit which is touched when the size of grains become too small to retain its magnetization at room temperature for a sufficient period of time.

A potential solution for the problem is to use instead of a continious thin film media a patterned media where each magnetic bit cell is formed as a lithographically defined magnetic element. These elements behave as single oriented magnetic domains being stable at room temperature. Moreover, each of these lithographically defined magnetic elements can be individually switched and read. An added advantage is that the transitions from one magnetic state to another one are much sharper than those in a continious medium. It is required to arrange these magnetic elements in periodic arrays to be synchronized with the read/write signal.

A major obstacle to the realization of a patterned magnetic storage media is the difficulty of a mass production of a suitable patterned substrate at an acceptable cost. The considerably high areal density above 100 Gbits/inch² requires bit sizes to be well below 100 nm in length and/or width. Therefore, in a suitable production technique, large areas have to be patterned having a comparably high resolution of the periodic structure at acceptable throughput and cost. Electron beam lithography is capable of producing such patterns but the throughput is far from being acceptable. Laser interference lithography has long been regarded as a possible technique as it can create periodic patterns over comparably large areas. However, up to now interference lithography has been shown to create only linear periodic structures such as arrays of lines or arrays of dots on square, rectangular or hexagonal grids.

Therefore, it is the aim of the invention to provide a method allowing to generate periodic curved structures overcoming these afore-mentioned limitations.

This aim is achieved according to the invention by a method for generating a periodic circular structure in a basic support material, such as a support layer for a patterned magnetic storage device, comprising:
a) generating a number of masks with each mask having at least two transmission diffraction gratings, each grating having a periodic concentric circular and/or spiral-like periodic pattern;b) positioning one or more of said masks, successively if two or more masks are used, at a certain distance of the basic support material to be patterned, with the distance being dependent on the mask;
c) applying light beams through each of the diffraction masks for exposing the basic support material to said light beam;
d) interfering the light beams diffracted by the gratings on each mask in order to generate coincident light intensity pattern on the surface of the basic support material;
e) repeating the exposure procedure a number of times with different masks to obtain a desired pattern of a periodic circular structure with possible partitioning in the circumferential direction

This new and inventive interference technique allows creation of periodic curved structures such as concentric circular tracks and periodic arrays of dots on circular tracks are achievable. This technique significantly relies on transmission diffraction masks having diffraction gratings that can be patterned by known lithographic techniques including electron beam lithography. This technique retains most of the main advantages of interference lithography such as high spatial resolution, large depth of focus, large pattern area, simplicity of the optical equipment and set up, coherence of the achieved pattern etc.

In accordance with an optional feature of the invention for exposing the basic support material a multiple exposure process is used, comprising: using a transmission diffraction mask having a periodic circular interference mask pattern in order to generate necessary exposure for circular tracks on the basic support material; and using afterwards a transmission diffraction mask having a spiral extending interference mask pattern in order to generate necessary exposure for a circumferential partitioning of said circular tracks; or vice versa. In a multiple exposure scheme the pattern is a result of the total dose pattern delivered to the basic support material. Individual exposure steps may or may not deliver sufficient dose to the support material to create patterns of their own.

An alternative multiple exposure process for exposing the basic support material may provide a multiple exposure process, comprising: using a first transmission diffraction mask having a combined circular and spiral interference mask pattern in order to generate necessary exposure for a first spiral track pattern on the basic support material; and using afterwards a second transmission diffraction mask having a similar combined circular and spiral extending interference mask pattern but having the spiral component oriented in the opposite direction in comparison with the first transmission diffraction mask in order to generate necessary exposure for a partitioning of said generated first spiral track pattern by intersecting the first and the second spiral track pattern.

Both the two processes as given above are interesting options for accommodating the inventive idea to practise.

In order to create diffracted beams, the transmission diffraction masks are either of absorption or of phase shifting type or a combination of the two types. Whereby it may be remarked that the throughput is higher using the phase shifting type since the diffraction efficiency and hence the use of the light from the light source is more efficient. Another advantage of using a phase mask is that the risk of damaging the mask at high fluences is minimized since no or little light is absorbed by the mask itself.

As far as the polarization of the incident light is important in the diffraction of light by the transmission diffraction masks (gratings), linearly polarized light may cause non uniformities along the circumferential direction in the created pattern. Therefore, a light source having a circular polarization and/or a linear polarization whereby the polarization plane of the light varies over the exposure time may be used to avoid such non-uniformities.

With respect to the storage density achievable according to the invention suitable light sources are necessary having a wavelength in the range of 5 to 500 nm, i.e. in the range from optical lasers to synchroton radiation sources. For example, lasers with 193 nm wavelength are currently used for lithography processes in the semiconductor industry. Lasers with 157 nm wavelength are expected to be used for smaller architectures in the future. With the latter light source, interference lithography will find entrance into dimensions less than 100 nm feature size. With respect to shorter wavelengths, synchroton radiation provides spatially coherent radiation with wavelengths down to 10 nm. In this range of wavelengths storage densities in the range of 10 Tbit/inch² seem to be possible.

In order to decrease the feature size using common laser light sources an immersion lithography process may be used, whereby an immersion liquid having a refractive index larger than 1 is disposed between the transmission diffraction mask and the basic support material. Assuming p.e. a laser light source having a wavelength of 157 nm and an immersion liquid with refractive index 1.37, a pattern period that approaches 55 nm can be expected. The corresponding storage density lays in the range of 210 Gbit/inch².

According to the selected structure of the transmission diffraction mask the gratings may be chosen in order to enable the partitioned circular periodic structure comprising cells having a length to width ratio other than 1. This type of elongated magnetic bit cells ensure that the elements have a certain long axis for easy magnetization and two well defined magnetic states oriented opposite to each other.

Other advantageous measures can be seen from the additional dependent claims.

Examples of the invention are described below with reference to the drawings which show in:
- Figure 1: a schematic layout of a first transmission diffraction grating configuration for creating an interference pattern with circular symmetry;
- Figure 2: an optical micrograph of an array of holes in a photoresist obtained with the transmission diffraction grating configuration shown in figure 1;
- Figure 3: a schematic layout of a second transmission diffraction grating configuration on two masks which can be used in a double exposure process; and
- Figure 4: a schematic layout of a third transmission diffraction grating configuration on two masks which can be used in a double exposure process.

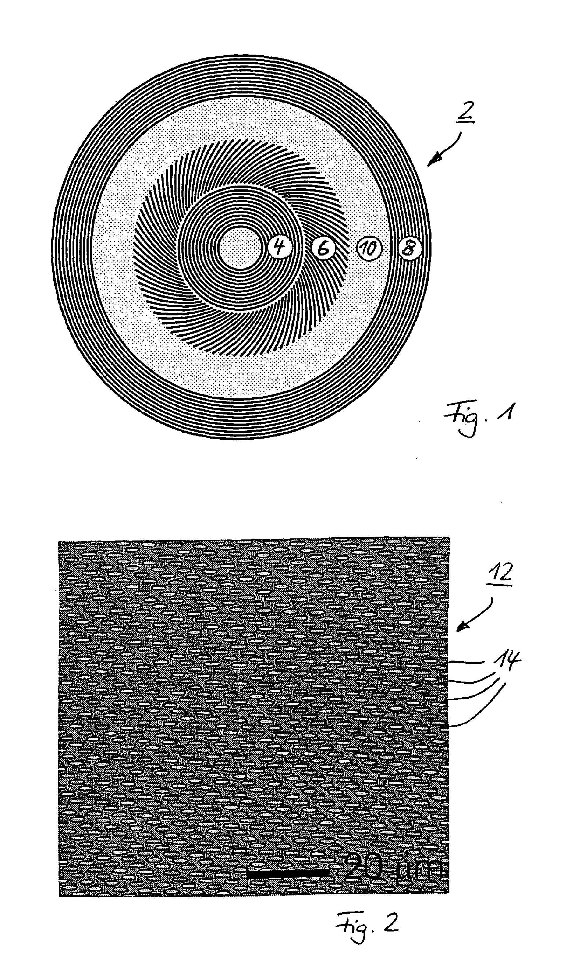

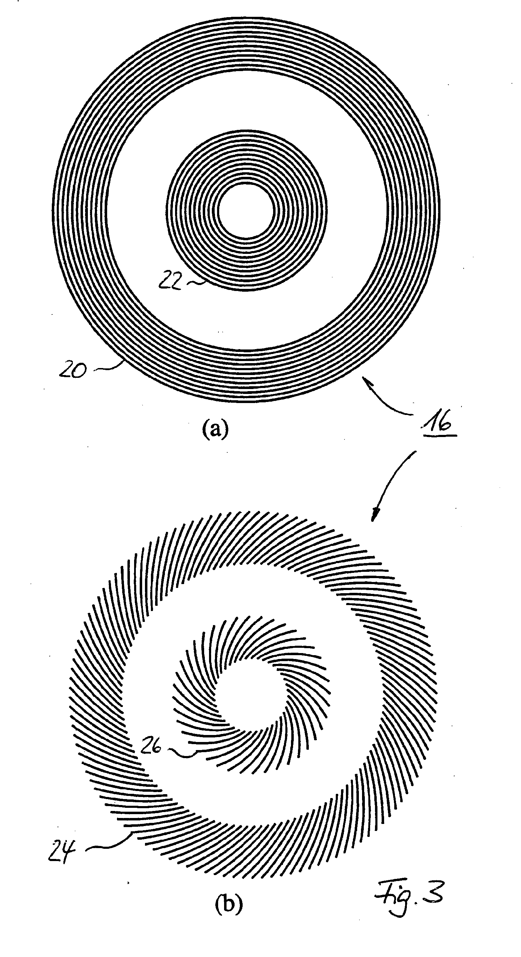

Generally, the method for generating a circular periodic structure for magnetic storage media starts with the design of a suitable number of transmission diffraction gratings. At least two of those gratings will create the desired interference pattern when illuminated by spatially coherent light. Figure 1 therefore shows a schematic layout of a first transmission diffration grating configuration 2 which comprises three different types of transmission diffration gratings 4, 6 and 8. These gratings 4, 6 and 8 have the design to generate a pattern of periodic partitioned dots 14 on circular tracks. When illuminated with spatially coherent light this mask design yields an interference pattern with periodic intensity peaks along circular tracks as shown in figure 2 that depicts an optical micrograph of an array of holes (dots) 14 in a photoresist layer 12 obtained with the first transmission diffraction grating configuration 2. The holes/dots 14 are positioned along circular tracks running parallel to the long axis of the oval shaped holes 14. The radius of the curvature of the tracks is about 6 mm so that the track curvature is not noticeable at magnifications large enough to resolve individual holes 14 as shown in figure 2.

The desired pattern on the photoresist layer 12, disposed on a suitable substrate, is obtained in this example by the interference of three mutually coherent beams of laser light. This periodic light pattern can then be used to create patterned magnetic bit cells with the desired circular symmetry in a single exposure step.

The light beams diffracted by the three transmission diffraction gratings 4, 6 and 8 coincide in a region 10 at a certain distance from the diffraction masks to form the desired interference pattern. The gratings 4 and 8 are designed to define circular tracks in the radial direction whereas the spiral grating 6 is designed to define the partition of the circular tracks into individual intensity peaks along the circumferential direction. Even though, the functions of these three transmission diffration gratings 4, 6 and 8 seem to be distinct, they are in this example required to be present simulataneously to obtain the desired interference pattern. Possible variations in the design of the gratings as shown in figure 1 include exchanging the relative radial locations of the different gratings 4, 6 and 8. The spatial periods of the gratings, their diameters, the angle (theoretically between 0 and 90°, preferably between 20 to 70°) of the spiral-like grating with respect to the radial direction can all be changed according to the application requirements, i.e. the desired storage density, size of the patterned region etc. The number of gratings can also be varied to obtain interference of two, three or four beams. Even a larger number may not be excluded.

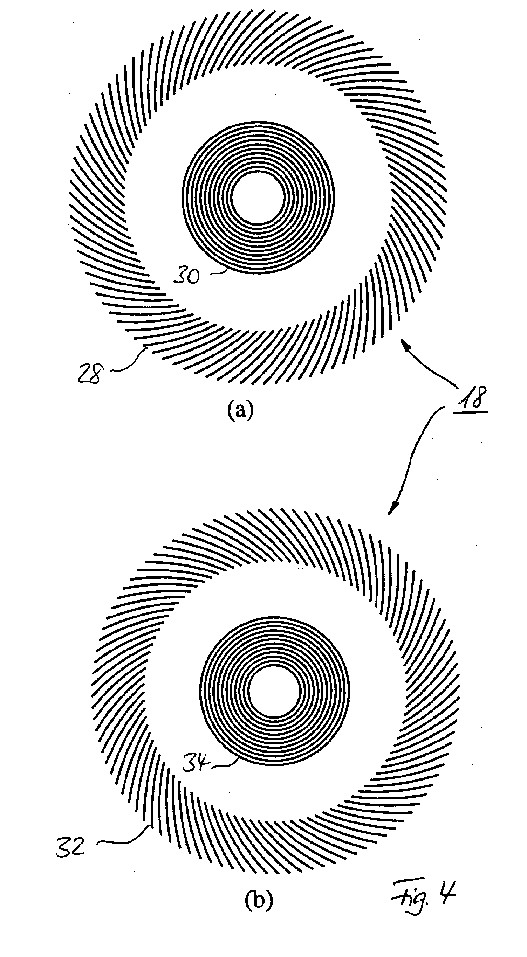

A promising possibility is the use of a multiple exposure process in order to obtain the desired pattern. Therefore, a second and a third transmission diffraction grating configuration 16 resp. 18 in figure 3 resp. 4 are shown to support this possibility. For example, a basic support material can be exposed first with two transmission diffraction gratings 20, 22 having circular patterns in order to obtain necessary exposure for circular tracks (Fig. 3a). This first exposure step is followed by a second exposure step using two transmission diffraction gratings 24, 26 having spiral gratings in order to obtain necessarry exposure for a circumferential partitioning of the circular tracks obtained by the first exposure step.

Another possible multiple exposure process scheme includes according to the third transmission diffraction grating configuration 18 in figure 4 a first exposure step with two transmission diffraction gratings 28, 30 having a combined circular and spiral grating in order to obtain necessary exposure for a first track pattern. In a second exposure step, two gratings 32, 34 having a combined circular and spiral grating, too, are used to obtain necessary exposure for a partitioning of the first track pattern. For this purpose, the directions of the spiral grating of the transmission diffraction gratings 28 and 32 are oriented opposite to each other.

The described method yields a circular pattern in an annular region, such as region 10 in Figure 1. In order to cover larger radial sections a multiple exposure process with different transmission diffractions masks can be used. This measure assists in maintaining a high spatial resolution in outer regions of the patterned area as the number of magnetic bit cells along the circumferential length is constant in the ensemble of circular tracks generated by one of the transmission diffraction grating configurations, such as the ones shown in figure 1, 3 or 4.

The afore-mentioned technique can be considered as a form of replication process even though the pattern of the master (the transmission diffraction masks) and the replica (the circular pattern for magnetic bit cells) are rather different. A noteworthy advantage in this replication process is that the spatial frequency of the resultant circular pattern for the magnetic bit cells is higher than that of the transmission diffraction masks. A frequency multiplication by a factor between 1 and 2 is possible and often obtained. Therefore, the spatial resolution requirements in the manufacturing of the transmission diffraction masks are relieved with respect to the desired magnetic pattern resolution.

Additionally, this technique allows to generate a pattern having partitioned cells with a distinct length to width ratio. Elongated cells own the advantage that the cells have a certain long axis for easy magnetization, and two opposite well defined magnetization states.

The transfer of the interference intensity pattern generated by exposing light via the transmission diffraction masks to a basic support material for the latter storage device into the magnetic bit cell structure can be done in various ways. Well known lithographic techniques using photoresist films can be used. It shall be mentioned that in this regard the photoresist film is considered as the basic support material. The photoresist film itself can be disposed on a suitable carrier material, made from plastic, ceramic and/or metal which may or may not be already coated with the magnetic media to be patterned. In this patterning technique the photoresist film is exposed to the interference field. The pattern is created in the the photoresist film after a development process where either the exposed or unexposed areas of the photoresist are dissolved depending on the tone of the photoresist (positive or negative resp.). The photoresist pattern is then transferred into a magnetic bit cell pattern using either a subtractive (dry or wet etching) or additive (lift-off or electroplating) process. Other possibilities include direct generation of the magnetic bit cell pattern by the influence of the interference light on the material to be patterned. For example, patterns of magnetic bit cells have been created by exposing the materials directly with laser beams and ion beams. Working without a photoresist has the general advantage in avoiding the dissolving process what means in particular that a possible damaging effects of the photoresist processing steps on the magnetic material is suppressed.

Additionally, a photoresist-less processing creates the magnetic bit cell pattern while maintaining the original smooth surface with no or to a very limited extend added topography. This is an important desired feature for patterned magnetic media since the magnetic read/write head hovers over the surface with an extremely small (several tens of nanometers) gap between the head and the spinning storage disc. Therefore, topographic features on the surface may disrupt the smooth hovering flight of the head or even collide with the head.

The interference lithography technique can be used in combination with the nanoimprint lithography. In that case, the circular interference lithography can be used to create stamps which can be later used in the nanoimprint process for mass replication. The advantage here is to produce the stamps in a much higher throughput process than using electron beam lithography. Unlike masks in photon based technique, the lifetime of a nanoimprint stamp is limited due to the contact nature of the process requiring a considerable number of stamps to be produced.

The interference process is able to create patterns having perfect periodicity properties which is of superior importance in the synchronization of the read/write signals. Well defined circular tracks may be used to create a sufficient feedback signal for the head to follow the tracks. This can be accomplished either by using the signal from the read head directly or by including additional elements on the head which picks up signal from several tracks in the adjacent vicinity.

## Claims

1. A method for generating a periodic circular structure in a basic support material, such as a layer for magnetic bit cells (14) for a magnetic storage device, comprising:
a) generating a number of masks with each mask having at least two transmission diffraction gratings (4, 6, 8, 20 to 34) each having a different periodic concentric circular and/or spiral-like periodic pattern;
b) positioning of one or more of said diffraction masks successively in a certain distance of the basic support material (12) to be patterned, with the distance depending on the mask;
c) applying light beams through each of the diffraction masks for exposing the basic support material (12) to said light beam;
d) d) interfering the different light beams diffracted by the gratings on each mask in order to generate conincident light intensity pattern on the surface of the basic support material (12).

2. The method according to claim 1,
**characterized in that**
for exposuring the basic support material (12) a multiple exposure process is used, comprising:
using a transmission diffraction mask (20, 22) having a periodic circular interference mask pattern in order to generate necessary exposure for circular tracks on the basic support material (12); and using afterwards a transmission diffraction mask (24, 26) having a spiral extending interference mask pattern in order to generate necessary exposure for a circumferential partitioning of said generated circular tracks; or vice versa.

3. The process according to claim 1,
**characterized in that**,
for exposuring the basic support material (12) a multiple exposure process is used, comprising:
using a first transmission diffraction mask (28, 30) having a combined circular and spiral interference mask pattern in order to generate necessary exposure for a first spiral track pattern on the basic support material (12); and
using afterwards a second transmission diffraction mask (32, 34) having a similar combined circular and spiral extending interference mask pattern but having the spiral component oriented in the opposite direction in comparison with the first transmission diffraction mask (28, 30) in order to generate necessary exposure for a partitioning of said generated first spiral track pattern by intersecting the first and the second spiral track pattern.

4. The process according to any one of the preceding claims,
**characterized in that**
the transmission diffraction masks (4, 6, 8, 20 to 34) are either of absorption or of phase shifting type.

5. The process according to any one of the preceding claims,
**characterized in that**
the light source delivers light having a circular polarization or a linear polarization that varies during the exposure time.

6. The process according to any one of the preceding claims,
**characterized in that**
the light source having a wavelength in the range of 5 to 500 nm, i.e. in the range from synchroton radiation sources to optical lasers.

7. The process according to claim 6,
**characterized in that**
an immersion lithography process is used, whereby an immersion liquid having a refractive index larger than 1 is disposed between the transmission diffraction mask (4, 6, 8, 20 to 34) and the basic support material (12).

8. The process of any one of the preceding claims,
**characterized in that**
the partitioned circular periodic structure having cells (14) having a length to width ratio larger than 1.
